# EUROPEAN PATENT APPLICATION

(11) **EP 1 940 030 A2**
(43) Date of publication of application: **02.07.2008**
(21) Application number: 07150425.2
(22) Date of filing: 27.12.2007
(51) Int. Cl.: H03M 1/12

(54) **Analog-to-digital converter and converting method thereof**

(30) Priority: 29.12.2006 KR 20060138983
(71) Applicant: LS Industrial Systems Co., Ltd, Seoul 100-801 (KR)
(72) Inventor: Park, Byung Chul 1,Songjeong-dong, Cheongju-si (KR)
(74) Representative: Holmberg, Magnus

(57) **Abstract**

The ADC (Analog-to-Digital Converter) and Analog-to-Digital Conversion method thereof are disclosed, wherein analog signals of a plurality of channels are sequentially sampled to be converted to corresponding digital signals but without being compensated in phase delays, and wherein a plurality of analog signals respectively inputted into a plurality of channels are sequentially and alternatively selected in forward and backward directions by a forward/backward switching unit, and the analog signals selected by the forward/backward switching unit are sampled and held by a sampling/holding unit, and the held analog signals are converted to corresponding digital signals by an Analog-to-Digital Conversion unit, whereby accumulated average values of phase delays generated by the sequential sampling of the analog signals in the plurality of channels are made to be equal, resulting in no need of compensating the phase delays.

## Description

### CROSS-REFERENCE TO RELATED APPLICATION

The present application is based on, and claims priority from, Korean Application Number 10-2006-0138983, filed December 29, 2006, the disclosure of which is incorporated by reference herein in its entirety.

### BACKGROUND

The following description relates generally to an ADC (Analog-to-Digital Converter) and Analog-to-Digital Conversion method thereof capable of converting an analog signal to a corresponding digital signal and a converting method thereof. More particularly, the following description relates to an ADC and a converting method thereof capable of obtaining an effect of simultaneously sampling plural channels of analog signals when the plural channels of analog signals are converted to corresponding digital signals using a single ADC.

Typically, ADCs for converting plural channels of analog signals to digital signals can be categorized into two types based on sampling type of plural channels of analog signals, that Is, a simultaneous sampling ADC and a sequential sampling ADC.

The simultaneous sampling ADC simultaneously samples analog signals of plural channels and differentially converts the sampled analog signals of plural channels to corresponding digital signals. There is an advantage in the simultaneous sampling ADC in that it can simultaneously sample analog signals of plural channels and there occurs no time difference and phase difference between analog signals of each channel. However, the simultaneous sampling ADC has a shortcoming in that it can hardly be embodied in hardware allocation techniques and is expensive over the sequential sampling ADC.

The sequential sampling ADC sequentially and selectively samples analog signals of plural channels and converts the each sampled analog signal to a corresponding digital signal. There is an advantage in the sequential sampling ADC in that it can be easily performed in hardware allocation techniques and is inexpensive over the simultaneous sampling ADC. However, there is a shortcoming in that phase difference and time difference are generated, which must be compensated as analog signals of plural channels are sequentially and selectively sampled. A known art to overcome the shortcoming is that each channel is disposed with an ADC to simultaneously convert the analog signal of each channel to a corresponding digital signal, which however necessitates to equip as many ADCs as the number of channels, thereby increasing the manufacturing cost in proportion to the number of channels.

Still another known art to solve the shortcoming is that a separate hardware is needed to configure a phase compensator for phase delay, dispensing with a phase compensator at a digital signal processor. However, to compensate the phase delay with hardware allocation techniques tends to complicate the construction of the hardware to thereby increase the cost resultant from the construction with the hardware allocation.

### SUMMARY

In view of these and other shortcomings of the prior art, one object of the present disclosure is to provide an ADC (Analog-to-Digital Converter) and converting method capable of sequentially sampling analog signals of plural channels to convert the analog signals to corresponding digital signals without compensating the phase delay.

A further object is to provide an ADC (Analog-to-Digital Converter) and Analog-to-Digital converting method capable of offsetting the phase delay generated by sequentially sampling analog signals of plural channels through mutual accumulation and equalization of the generated phase delays.

The present novel disclosure provides an ADC and converting method thereof, wherein analog signals of plural channels are sequentially selected in the forward direction to sample and hold the analog signals, and the analog signals are converted to corresponding digital signals. When the analog signals of plural channels are completed in forward direction of selection, the analog signals of plural channels are sequentially and reversely selected to sample and hold the analog signals, and the analog signals are converted to corresponding digital signals. Therefore, the accumulated average values of phase delay generated by sequential selection of analog signals of plural channels are equalized, resulting in dispensing with compensation of the phase delay,

In one general aspect, an ADC (Analog-to-Digital Converter) comprises: a forward/backward switching unit for alternative sequential selection of analog signals of plural channels in forward and backward directions; a sampling/holding unit for sampling and holding the analog signals selected by the forward/backward switching unit; and an ADC (Analog-to-Digital Converter) unit for converting the analog signals sampled and held by the sampling/holding unit to corresponding digital signals.

The ADC further comprises a digital signal processor for processing the digital signals converted by the ADC unit, and the forward/backward switching unit alternatively and sequentially selects the analog signals of plural channels in forward and backward directions in response to a control signal generated by the digital signal processor

In another general aspect, an Analog-to-Digital Conversion method comprises: alternatively and sequentially selecting in forward and backward directions, by a forward/backward switching unit, analog signals of plural channels respectively inputted via plural channels; sampling and holding, by the forward/backward switching unit, the analog signals selected by the forward/backward switching unit; and converting, by an Analog-to-Digital Conversion unit, the held analog signals to corresponding digital signals.

### BRIEF DESCRIPTION OF THE DRAWINGS

The following detailed description of the instant disclosure is in reference to accompanying drawings, which form a part of this description. The description is of illustrative examples of various implementations in which the disclosure may be practiced. The present novel concept is not limited to the specific illustrative examples. In the drawings, like numerals appearing in different drawings, either of the same or different implementations of the disclosure, reference functional or system blocks that are, or may be, identical or substantially identical between the different drawings.
FIG.1 is a schematic prior art block diagram illustrating configuration of an Analog-to-Digital Converter.
FIG2 is a schematic block diagram illustrating configuration of an Anal og-to- Digital Converter.
FIG3 is a flowchart illustrating an Analog-to-Digital Conversion method.

### DETAILED DESCRIPTION

The hereinafter detailed description which is an exemplary implementation, although the present teachings are not limited to any exemplary implementation, is provided simply to explain the principle and concept of the novel knalog-to-Digital Convener and method thereof. Other configurations and arrangements embodying or practicing the present disclosure can be readily implemented by persons skilled in the arts, upon reading this description.

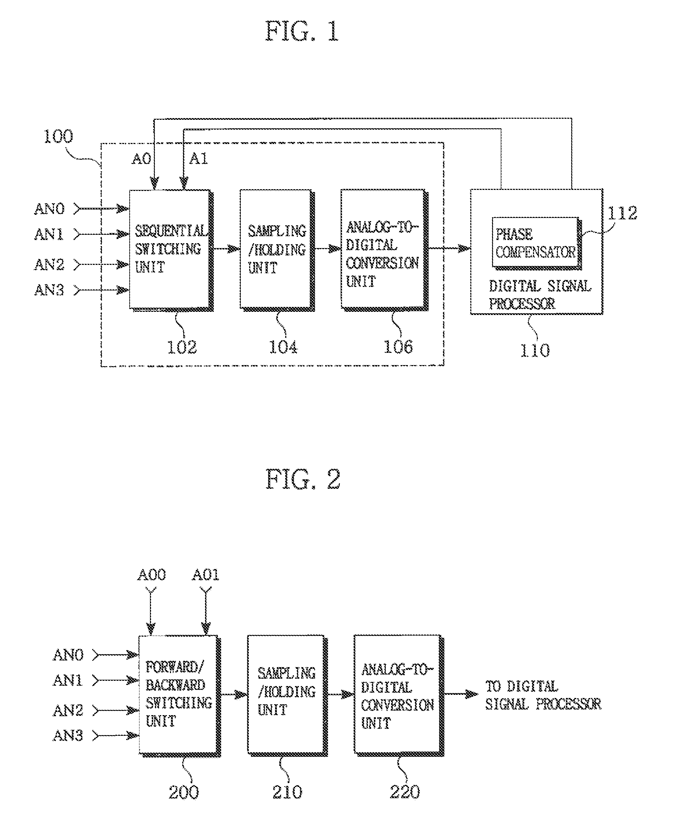

FIG.1 is a schematic prior art block diagram illustrating configuration of an Analog-to-Digital Converter, where reference numeral 100 defines an Analog-to-Digital Converter (ADC), and reference numeral 110 is a digital signals processor.

The ADC (100) may include a sequential switching unit (102), a sampling/holding unit (104) and an Arialog-to-Digital Conversion unit (106).

The sequential switching unit (102) may sequentially select one by one a plurality of analog signals inputted through a plurality of channels (ANO, AN1, AN2, AN3) in response to control signals (AO, A1) outputted from the digital signal processor (110),

The sampling/holding unit (104) may sample an analog signal of a prescribed channel switched and selected by the sequential switching unit (102), and hold the sampled analog signal and output to the Analog-to-Digital Conversion unit (106).

The digital signal processor (110) may generate control signals (AO, A1) to control the switching operation of the sequential switching unit (102). Furthermore, the digital signal processor (106) may be inherently disposed with a phase compensator (112). The phase compensator (112) may perform compensation of phase difference and time difference between the digital signals converted from analog signals of the plurality of channels (AN0, AN1, AN2, AN3).

When the plurality of analog signals inputted from the plurality of channels (ANO, AN1, AN2, AN3) is converted to corresponding digital signals in the sequential sampling ADC, the digital signal processor (110) may generate control signals (AO, A1), and the generated control signals (AO, A1) may be inputted into the sequential switching unit (102) of the ADC (100).

Successively, the sequential switching unit (102) may sequentially select the analog signals of the plurality of channels (ANO, AN1, AN2, AN3) in response to the control signals (AO, A1). The analog signals selected by the sequential switching unit (102) may be sampled by the sampling/holding unit (104).

In other words, the analog signal of the channel (ANO) may be selected by the sequential switching unit (102) in response to the control signals (AO, A1) and sampled by the sampling/holding unit (104). Thereafter, the sequential switching unit (102) may sequentially select the analog signals of channels (AN1, AN2, AN3) in response to the control signals (AO, A1) and the sampling/holding unit (104) may sample the selected analog signals, where the sequential switching unit (102) may sequentially sample one by one the plural analog signals of the plurality of channels (ANO, AN1, AN2, AN3).

The analog signals sequentially sampled by the sampling/holding unit (104) may be held by the sampling/holding unit (104) and outputted to the Analog-to-Digital Conversion unit (106). The Analog-to-Digital Conversion unit (106) may convert the analog signals held by the sampling/holding unit (104) to corresponding digital signals.

At this time, because the sequential switching unit (102) sequentially switches the analog signals of the plurality of channels (ANO, AN1, AN2, AN3) in response to the control signals (AO, A1), there occurs a phase difference and a time difference among the digital signals of each channel (AN0, AN1, AN2, AN3) outputted from the Analog-to-Digital Conversion unit (106), where the phase and time differences must be compensated.

The digital signal processor (110) may generate the control signals (AO, A1) before processing the digital signals converted by the Analog-to-Digital Conversion unit (106), where the phase difference generated by the sequential switch by the sequential switching unit (102) of the analog signals of the plurality of channels (ANO, AN1, AN2, AN3) may be compensated software-wise by the phase compensator, and the digital signals compensated in phase delay may be processed by the digital signal processor (110).

The phase delay generated by the sequential sampling of the analog signals of the plurality of channels by the sequential sampling analog/digital converter may be compensated by the phase compensator (112) of the digital signal processor (11 10). The phase compensation may be mainly compensated using non-linear functions.

As a result, the operation capability of the digital signal processor may be spent for compensating the phase delay to a large extent, whereby an overload is applied to the digital signal processor and a great many hours are spent for signal processing as well. In addition, numerical errors generated in the course of compensating the phase delay may result in distortion of original signals, making it difficult to expect a good and clean result of the signal processing.

FIG2 is a schematic block diagram illustrating configuration of an Analo-to-Digital Converter.

Referring to FIG.2, the ADC of the present disclosure may include a forward/backward switching unit (200), a sampling/holding unit (210), an Analog-to-Digital Conversion unit (220) and a digital signal processor (230),

The forward/backward switching unit (200) may select the analog signals of the plurality of channels (AN0, AN1, AN2, AN3) in response to the inputted control signals (A00, A01) by forward switching of the analog signals of the plurality of channels (ANO, AN1, AN2, AN3), and if the forward switching is completed, a backward (reverse) switching is selected, where the forward and backward switching may be repeated.

The sampling/holding unit (210) may sample an analog signal of a prescribed channel selected by switching by the forward/backward switching unit (200), and hold the sampled analog signal and output the analog signal to the Analog-to Digital Conversion unit (220). The Analog-to-Digital Conversion unit (220) may convert to a digital signal the held signal inputted from sampling/holding unit (210).

The digital signal processor (230) may generate control signals (A00, A01) to control the switching operation of the forward/backward switching unit (200). Furthermore, the digital signal processor (230) may receive the digital signal converted by the Analog-to-Digital Conversion unit (220) to execute a prescribed operation.

In the ADC thus constructed, the plurality of analog signals may be respectively inputted into the plurality of channels (ANO, AN1, AN2, AN3). The digital signal processor (230) may generate a forward control signals (A00, A01) for sequentially forward-switching the plurality of analog signals respectively inputted to the plurality of channels (ANO, AN1, AN2, AN3). The generated forward control signals (A00, A01) are applied to the forward/backward switching unit (200).

The forward/backward switching unit (200) may select the analog signals of the plurality of channels (AN0, AN1, AN2, AN3) in response to the inputted control signals (A00, A01) by forward switching of the analog signals of the plurality of channels (ANO, AN1, AN2, AN3), and if the forward switching of the plurality of analog signals inputted from the plurality of channels (ANO, AN1, AN2, AN3) is completed, the digital signal processor (230) may generate backward control signals (A00, A01) for sequentially backward-switching of the plurality of analog signals inputted from the plurality of channels (ANO, AN 1, AN2, AN3).

Successively, the forward/backward switching unit (200) may select the plurality of analog signals inputted from the plurality of channels (ANO, AN1, AN2, AN3) by sequentially backward-switching in response to the backward control signals (A00, A01).

In other words, the forward/backward switching unit (200) may select by sequentially switching the plurality of analog signals respectively inputted from the plurality of channels (ANO, AN1, AN2, AN3) in the forward order of AN0→AN1→AN2→AN3 in response to the forward control signals (A00, A01). Furthermore, if the forward switching has been completed up to the analog signal of the channel (AN3), the forward/backward switching unit (200) may select by sequentially switching the plurality of analog signals respectively inputted from the plurality of channels (ANO, AN1, AN2, AN3) in the backward order of AN3→AN2→AN1→AN0 in response to the backward control signals (A00, A01).

As noted above, the analog signals selected by forward and backward switching of the forward/backward switching unit (200) may be inputted to the sampling/holding unit (210) to be sampled and held. The analog signals held by the sampling/holding unit. (210) may be converted to digital signals by the Analog-to-Digital Conversion unit (220), and inputted to and processed by the digital signal processor (230).

The ADC of the present disclosure can select, by sequential alternative switching of the analog signals inputted by the forward/backward switching unit (200) to the plurality of channels (ANO, AN1, AN2, AN3) in the forward and backward directions. The selected analog signals can be sampled and held by the sampling/holding unit (210) and converted to digital signals by the Analog-to-Digital Conversion unit (220).

In so doing, the digital signals of the plurality of channels (ANO, AN1, AN2, AN3) outputted by the Analog-to-Digital Conversion unit (220) may have the same accumulated average value of phase delays in which mutual phases are delayed. As a result, this operation may obtain the same result as that of the simultaneous sampling of the analog signals of the plurality of channels (ANO, AN1, AN2, AN3) and conversion to digital signals, such that there may be no need of phase adjustment of the digital signals outputted from the Analog-to-Digital Conversion unit (220),

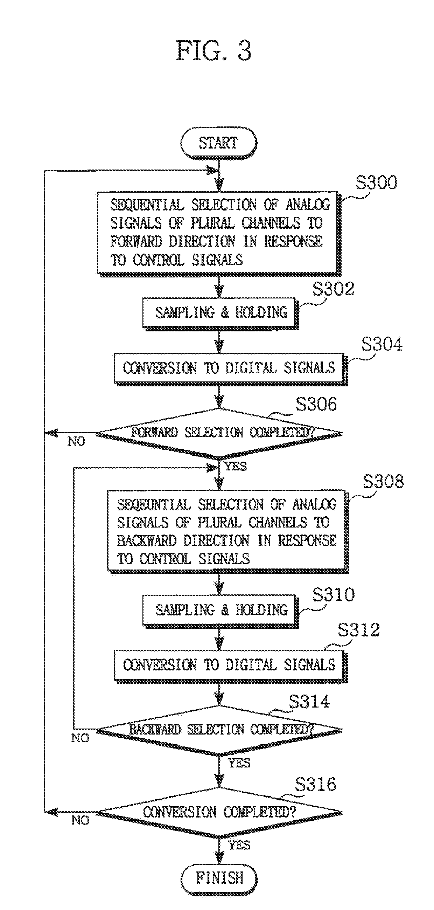

FIG.3 is a flowchart illustrating an Analog-to-Digital Conversion method.

Now, referring to FIG3, if the plurality of analog signals respectively inputted into the plurality of channels (ANO, AN1, AN2, AN3) are converted to digital signals, the forward/backward switching unit (200) may select the analog signals of the plurality of channels (ANO, AN1, AN2, AN3) by sequentially forward-switching one by one in response to the control signals (A00, A01) inputted from outside (S300).

The analog signals selected and switched by the forward/backward switching unit (200) may be inputted to the sampling/holding unit (210) to be sampled and held (S302). The analog signals held by the sampling/holding unit (210) may be converted to digital signals by the Analog-to-Digital Conversion unit (220) (S304).

Under this circumstance, the digital signal processor may determine whether the plurality of analog signals inputted to the plurality of channels (ANO, AN1, AN2, AN3) have been sequentially forward-switched one by one (S306). As a result of the determination, if it is determined that the plurality of analog signals inputted to the plurality of channels (ANO, AN1, AN2, AN3) have not been sequentially forward-switched and selected one by one, flow returns to the above-mentioiied step (S300), where the forward/backward switching unit (200) may sequentially forwardly switch and select one by one the analog signals of the plurality of channels (ANO, AN1, AN2, AN3), the sampling/holding unit (210) may sample and hold the selected analog signals, and the Analog-to-Digital Conversion unit (220) may repeat the conversion operation of converting the held analog signals to digital signals.

As a result of the determination, if it is determined that the plurality of analog signals inputted to the plurality of channels (ANO, AN1, AN2, AN3) have been sequentially forward-switched and selected one by one, the forward/backward switching unit (200) may sequentially backwardly switch and select one by one the analog signals of the plurality of channels (ANO, AN1, AN2, AN3) in response to the control signals (A00, A01) that are inputted from outside (S308),

The analog signals switched and selected by the forward/backward switching unit (200) may be inputted to he sampling/holding unit (210) to be sampled and held (S310), and the analog signals held by the sampling/holding unit (210) may be converted to digital signals by the Analog-to-Digital Conversion unit (220) (S312).

Under this circumstance, the digital signal processor may determine whether the plurality of analog signals inputted to the plurality of channels (ANO, AN1, AN2, AN3) have been sequentially backward-switched and selected one by one (S314).

As a result of the determination, if it is determined that the plurality of analog signals inputted to the plurality of channels (ANO, AN1, AN2, AN3) have not been sequentially backward-switched and selected one by one, flow returns to the above-mentioned step (S300), where the forward/backward switching unit (200) may sequentially backwardly switch and select one by one the analog signals of the plurality of channels (ANO, AN1, AN2, AN3), the sampling/holding unit (210) may sample and hold the selected analog signals, and the Analog-to-Digital Conversion unit (220) may repeat the conversion operation of converting the held analog signals to digital signals.

As a result of the determination, if it is determined that the plurality of analog signals inputted to the plurality of channels (AN0, AN1, AN2, AN3) have been sequentially backward-switched and selected one by one, the digital signal processor may determine whether the digital conversion of the analog signals have been completed (S316),

As a result of the determination, if it is determined that the digital conversion has not been completed, flow returns to the step (S300), where the forward/backward switching unit (200) may sequentially forwardly switch and select one by one the analog signals of the plurality of channels (ANO, AN1, AN2, AN3), the sampling/holding unit (210) may sample and hold the selected analog signals, and the Analog-to-Digital Conversion unit (220) may convert the held analog signals to digital signals.

As a result of the if it is determined that the forward selection has been completed, the forward/backward switching unit (200) may sequentially backwardly switch and select one by one the analog signals of the plurality of channels (AN0, AN1, AN2, AN3), the sampling/holding unit (210) may sample and hold the selected analog signals, and the Analog-to-Digital Conversion unit (220) may repeat the operation of converting the held analog signals to digital signals.

If it is determined as a result of the determination at step (S316) that the digital conversion has been completed, the digital conversion operation is terminated.

Meanwhile, the foregoing discussion has been concretely described based on the exemplary implementations where analog signals inputted into the plurality of channels (ANO, AN1, AN2, AN3) are sequentially forwardly and backwardly selected and converted to digital signals. However, it is needless to say that the present disclosure is not limited to the foregoing implementations and various modifications and alterations can be made within the scope of the present novel concept. For example, configuration may be made in such a fashion that analog signals inputted to channels less than or more than 4 channels may be sequentially and selectively converted to digital signals. In this case, the number of control signals may vary responsive to the number of channels into which analog signals are inputted.

As is evident from the foregoing discussion, when analog signals of a plurality of channels are sampled and held, the analog signals of the plurality of channels are sequentially selected one by one in the forward direction to be sample and held, and converted to digital signals. If the forward selection has been completed, the analog signals of plurality of channels are sequentially selected one by one in the backward direction to be sampled and held, and converted to digital signals, where these operations are repeated,

Therefore, the phase delay generated by the sequential selection of the analog signals of each channel is accumulatively averaged and mutually compensated, such that there is no need of compensating the phase delay of the digital signals, whereby loads of the digital signal processor can be reduced and the analog signals can be clearly converted to digital signals.

Additional advantages and modifications will readily occur to those skilled in the art. Therefore, the present novel concept in its broader aspects is not limited to the specific details and representative implementations shown and described herein. Accordingly, various modifications may be made without departing from the spirit or scope of the general inventive concept as defined by the appended claims and their equivalents.

## Claims

1. An ADC (Analog-to-Digital Converter) comprising: a forward/backward switching unit for alternative sequential selection of analog signals of plural channels in forward and backward directions; a sampling/holding unit for sampling and holding the analog signals selected by the forward/backward switching unit; and an ADC (Analog-to-Digital Converter) unit for converting the analog signals sampled and held by the sampling/holding unit to corresponding digital signals.

2. The ADC as claimed in claim 1, further comprising a digital signal processor for processing the digital signals converted by the ADC (Analog-to-Digital Converter) unit, and generating control signals for output to the forward/backward switching unit.

3. An Analog-to-Digital Conversion method comprising: alternatively and sequentially selecting in forward and backward directions, by a forward/backward switching unit, analog signals of plural channels respectively inputted via plural channels; sampling and holding, by the forward/backward switching unit, the analog signals selected by the forward/backward switching unit; and converting, by an Analog-to-Digital Conversion unit, the held analog signals to corresponding digital signals.
